Europäisches Patentamt

European Patent Office

Office européen des brevets

(19)

(11) Veröffentlichungsnummer: **0 289 844 B1**

(12) # EUROPÄISCHE PATENTSCHRIFT

(45) Veröffentlichungstag der Patentschrift: **01.07.92**

(51) Int. Cl.⁵: **B41N 1/08**, C22C 21/00

(21) Anmeldenummer: **88106165.9**

(22) Anmeldetag: **19.04.88**

(54) **Trägermaterial und Verfahren zu seiner Herstellung.**

(30) Priorität: **28.04.87 DE 3714059**

(43) Veröffentlichungstag der Anmeldung:
**09.11.88 Patentblatt 88/45**

(45) Bekanntmachung des Hinweises auf die
Patenterteilung:
**01.07.92 Patentblatt 92/27**

(84) Benannte Vertragsstaaten:
**AT BE CH ES FR GB IT LI LU NL SE**

(56) Entgegenhaltungen:
EP-A- 0 154 200          EP-A- 0 164 856
EP-A- 0 211 574          DE-A- 1 956 795
FR-A- 2 283 013          GB-A- 2 019 022
US-A- 4 098 619

(73) Patentinhaber: **VEREINIGTE ALUMINIUM-
WERKE AKTIENGESELLSCHAFT**
**Berlin - Bonn Postfach 2468 Georg-
von-Boeselager-Strasse 25**
**W-5300 Bonn 1(DE)**

Patentinhaber: **HOECHST AKTIENGESELL-
SCHAFT**
**Postfach 80 03 20**
**W-6230 Frankfurt am Main 80(DE)**

(72) Erfinder: **Scheel, Hartmut, Dipl.-Ing.**
**Anne-Frank-Weg 1**
**W-4048 Grevenbroich(DE)**
Erfinder: **Schmiedel, Helmut, Dr.**
**Ostlandstrasse 55**
**W-5000 Köln 40(DE)**
Erfinder: **von Asten, Wolfgang, Dipl.-Ing.**
**Ingendorferhöhe 19**
**W-5024 Pulheim 3(DE)**
Erfinder: **Scharf, Günther, Dr.**
**Brüsseler Strasse 80**
**W-5300 Bonn 1(DE)**
Erfinder: **Grzemba, Barbara, Dr.**
**Mozartstrasse 38**
**W-5300 Bonn 1(DE)**
Erfinder: **Sprintschnik, Gerhard, Dr.**
**Rossbachhöhe 30**
**W-6204 Taunusstein 4(DE)**
Erfinder: **Niederstätter, Walter, Dr.**
**Rilkeweg 1**
**W-6228 Eltville(DE)**
Erfinder: **Reiss, Kurt, Dr.**
**Lohmühlweg 7**
**W-6200 Wiesbaden(DE)**

EP 0 289 844 B1

**Beschreibung**

Die Erfindung betrifft ein Trägermaterial für eine Aluminiumflachdruckform, bestehend aus 0,2 - 0,6 % Eisen, weniger als 1 % Mangan, weniger als 0,25 % Silizium und Kupfer, Rest Aluminium und herstellungsbedingte Verunreinigungen, sowie ein Verfahren zu seiner Herstellung.

Es besteht Bedarf an Flachdruckplatten, die eine erhöhte Gebrauchsdauer (Druckauflage) haben. Diese kann durch Einbrennen bzw. Härten der Fotoschicht - einige Minuten bei 230 - 240 °C - erreicht werden; die Platte wird dadurch sehr abriebfest.

Für Druckplatten wird vorwiegend Rein-Al eingesetzt (s. auch Aluminium-Taschenbuch, 14. Auflage, S. 109), das sowohl in HCl-wie auch in $HNO_3$-Bädern elektrochemisch aufgerauht werden kann und danach ein helles, gleichmäßiges Aussehen zeigt. Rein-Al verliert beim Einbrennen jedoch relativ stark an Festigkeit, so daß dieser Werkstoff die gestiegenen Anforderungen an die Druckauflage nicht erfüllen kann.

Einige Plattenhersteller setzen deshalb die AlMn-Legierung AA 3003 ein, die ca 1 % Mn enthält und thermisch sehr viel stabiler ist als Rein-Al. Flachdruckformen aus Mn-haltigen Legierungen sind auch aus EPA 0 164 856 bekannt. Alle Mn-haltigen Legierungen besitzen den Nachteil, daß die Oberfläche im HCl-Bad nur mit veränderten Verfahrensparametern einigermaßen gut aufrauhbar, im $HNO_3$-Bad grundsätzlich sehr schlecht (ungleichmäßig) aufrauhbar ist. In beiden Säure-Systemen entsteht auf der Oberfläche ein dunkler Belag, der sich auf die kopiertechnischen Eigenschaften negativ auswirkt. In EPA 0 164 856 werden zu dem Aufrauhverhalten der AlMn-Werkstoffe in HCl einerseits und in $HNO_3$ andererseits sowie zum Aufrauhverhalten in Abhängig-keit vom Mn-Gehalt keine Angaben gemacht.

Aus DE-PS 25 57 222 ist ferner ein Verfahren zur Herstellung eines Al-Trägerbogens für Druckplatten durch Behandlung der Oberfläche in einer wäßrigen, chloridhaltigen Elektrolytlösung mit anschließender Anodisierung bekannt.

Aufgabe der vorliegenden Erfindung ist es, ein Trägermaterial für Aluminiumflachdruckformen bereitzustellen, das bei gleichzeitig guter thermischer Stabilität unter Einbrennbedingungen nach Aufrauhung in HCl- und $HNO_3$-Bädern eine gleichmäßigere und hellere Oberfläche als die Mn-haltigen Legierungen aufweist, vergleichbar der Oberflächenqualität, die bei Rein-Al erzielbar ist.

Erfindungsgemäß wird diese Aufgabe durch die in den Patentansprüchen angegebenen Merkmale gelöst. Es hat sich gezeigt, daß bei einem englimitierten Mn-Gehalt und unter Einhaltung einer bestimmten Fertigung ein Gefüge erzielt werden kann, das sowohl von dem Aufrauhverhalten als auch von der Thermostabilität her optimale Eigenschaften zeigt.

Es ist möglich, den erfindungsgemäßen Werkstoff im HCl- und $HNO_3$-Bad genauso gut elektrochemisch aufzurauhen wie Rein-Al. Überraschenderweise läßt sich die Aufrauhung im HCl- und $HNO_3$-System ohne eine Änderung der für Rein-Al eingestellten Badparamenter (Säure-Konzentration, Badtemperatur, Stromdichte) vornehmen. D.h. die Standardprozesse für Rein-Al können wahlweise - und damit wirtschaftlich - auch für die hier entwickelte AlMn-Legierung angewandt werden.

Thermische Stabilität

Anhand zahlreicher Versuche wurde erkannt, daß die Elemente Fe und Mn sowohl in gelöster Form als auch als feinste Ausscheidungen für die Thermostabilität verantwortlich sind. Der Eisengehalt von 0,2 - 0,6 % ist so gewählt, daß einerseits eine festigkeitssteigernde Wirkung durch gelöstes Fe und feinste AlFe-Ausscheidungen eintritt, und andererseits keine groben AlFeSi- und AlMnFeSi-Phasen >10 $\mu$m im Gußgefüge entstehen. Der Mangan-Zusatz von 0,1 - 0,3 % verursacht eine weitere Steigerung der thermischen Stabilität durch Mn in fester Lösung sowie durch feine AlMnSi-Ausscheidungen. Der Mangangehalt ist ausschließlich im Hinblick auf das Aufrauhverhalten limitiert: die AlMnSi- und AlMn-Phasen müssen sehr fein und dürfen nicht zu zahlreich sein, damit sie bei der elektrochemischen Aufrauhung nicht stören.

Legierungen ähnlicher Zusammensetzungen für Al-Flachdruckformen werden auch in der EPA 0 164 856 beschrieben. In diesem Zusammenhang ist darauf hinzuweisen, daß die Eigenschaften eines Werkstoffs nicht nur von der Analyse sondern auch vom Herstellungsprozeß bestimmt werden.

Dem erfindungsgemäßen Herstellungsprozeß liegt der Gedanke zu Grunde, daß es für die Eigenschaften der Aluminiumflachdruckform entscheidend auf die Art, Menge und dichte der Sekundärphasen im Trägermaterial ankommt. Anhand zahlreicher Versuche wurde ermittelt, daß zur Steuerung der Phasenausbildung wesentlich die Warmbandausbringungstemperatur beiträgt. Ferner ist es wichtig, daß vor dem Aufrauhen nicht, wie bspw. in EP-A O 164 856 beschrieben, ein Anlaßglühen bei Temperaturen von 150 - 200 °C durchgeführt wird. Vielmehr wird bei dem erfindungsgemäßen Verfahren unmittelbar nach dem Kaltwalzen an Enddicke und nach dem üblichen Recken und Entfetten das chemische Aufrauhverfahren in HCl- und $HNO_3$-Bädern durchgeführt, wie es in den Ansprüchen 11 ff. beschrieben ist.

Der hier entwickelte Werkstoff ist charakterisiert durch ein feines Ausscheidungsgefüge mit einem Dispersionsgrad <50-Phasen pro ($\mu m^3$). Die AlMnSi-, AlFe- und AlMn-Phasen müssen dabei <0,3 $\mu m$ bei einer mittleren Teilchengröße von 0.05 - 0,1 $\mu m$ sein. Das Mengenverhältnis der Phasen AlMnSi: AlFe : AlMn beträgt 1 : 1 : 2 bis 1 : 1 ; 3. Dies wird erreicht durch die in Anspruch 8 genannten Vefahrensparameter. Entscheidend ist auch im Hinblick auf EPA 0 164 856 - der Verzicht auf eine Erholungsglühung, denn je länger geglüht wird, desto größer und zahlreicher werden die Phasen.

Die thermische Stabilität des hier entwickelten Werkstoffs läßt sich aus den Festigkeitswerten in Tabelle 1 im Vergleich zu den handelsüblichen Werkstoffen Rein-Al und AlMn1Cu (3003) entnehmen.

## Elektrochemische Aufrauhung

Für die Prüfungen wurden AlMn-Legierungen mit Mn-Gehalten von 0,1 - 1 % Mn und Al99,5 unter identischen Bedingungen einmal in einem Salzsäure- und zum anderen in einem Salpetersäureprozeß aufgerauht. Die Bedingungen waren wie folgt:

Alkalische Beize: 4 %-ige Natronlauge bei 50 °C während 25 sec.

Salzsäure-System: 0,9 %-ige Salzsäure, enthaltend 1 % $AlCl_3$. $9H_2O$ bei 42 °C, einer Stromdichte von 98 A/$dm^2$ und einer Spannung von 30 - 50 V während einer Verweilzeit von 10 sec mit anschließender Zwischenbeize: 10 %-ige Schwefelsäure bei 50 °C während einer Zeit von 15 sec.

Salpetersäure-System: 1,2 %-ige Salpetersäure, enthaltend 2 % $Al(NO_3)_3$ • $6H_2O$, bei 48 °C, einer Stromdichte von 98 A/$dm^2$ und einer Spannung von 30 - 50 V während einer Verweilzeit von 10 sec.

## Anodisierung

bei Salpetersäureaufrauhung in 18 %-iger Schwefelsäure bei einer Spannung von 20 V, wobei das Oxidationsgewicht 4 g/$m^2$ betrug.

Nachbehandlung: in 35 %-iger Polyvinylphosphonsäure bei 50 °C (DE-PS 16 21 478).

Die Beschichtung erfolgte mit positiv arbeitendem strahlungsempfindlichem Gemisch folgender Zusammensetzung:

Schichtgewicht: 2 g/$m^2$

1,8      Teile eines Naphthochinondiazidsulfonsäureesters, hergestellt nach EP-OS 0 053 819

0,2      Teile eines Naphthochinondiazidsulfonsäurechlorids

1,8      Teile eines Kresol-Formaldehyd-Novolaks mit Schmelzbereich von 105 - 120 °C

0,1      Teile Kristallviolett gelöst in Ethylenglykolmonomethylether.

Um die Qualität der elektrochemischen Aufrauhung beurteilen zu können, wurden folgende Parameter ausgewählt:

1. Rauhtiefe

Die Rauhtiefe beeinflußt die spätere Verankerung der lichtempfindlichen Schicht mit dem Aluminium und somit auch die Entwickelbarkeit und Druckauflage.

● =      Rauhtiefe nach Aufrauhung im HCl-Bad

O =      Rauhtiefe nach Aufrauhung im $HNO_3$-Bad

2. Helligkeit

Die Druckplatten müssen einen möglichst hellen und gleichmäßigen Grauton aufweisen. Eine fleckige, streifige oder ungleichmäßig gefärbte Oberfläche ist nicht marktgerecht.

Ⓧ =      Helligkeit

3. Oxidresistenz

Von universell verarbeitbaren Druckplatten erwartet man, daß sie einerseits sehr schnell innerhalb weniger Sekunden verarbeitbar sind, andererseits aber gegen übermäßiges Entwickeln, unter Umständen auch gegen aggressivere Fremdentwickler weitgehend resistent sind. Insbesondere das Oxid kann von Alkali leicht zerstört werden. Dabei blüht die Oxidschicht kreidig-weiß auf.

Dieser Effekt ist abhängig von der Konzentration an Alkali und der Einwirkzeit und zeigt sich zuerst in

EP 0 289 844 B1

unmittelbarer Umgebung von anspruchsvollen Testelementen und in Halbtonstufen.

Bei intensiverer Einwirkung wird das Oxid flächig zerstört, wodurch die Lebensdauer der Druckplatte erheblich verkürzt wird. Außerdem neigen solche Platten dazu, nach einem Maschinenstillstand zu tonen, was nur durch aufwendige Reinigungsaktionen beseitigt werden kann.

$\Delta$ = Oxidresistenz

## 4. Farbschleier

Diese häufig bei Druckplatten auftretende Eigenschaft ist besonders nach der Korrektur sichtbar. Dabei handelt es sich um Farbstoff- und Schichtreste, die in den feinen Poren des Oxids adsorbiert werden und sich während des normalen Entwicklungsvorgangs nicht entfernen lassen. Erst das aggressivere Korrekturmittel macht die unvollständige Entwicklung augenscheinlich. Besonders an den Übergängen von korrigierten auf nicht korrigierte Flächen kann es beim Druckprozeß zu Störungen kommen, indem diese bildfreien Stellen Farbe annehmen. Von einer sehr guten Druckplatte erwartet man, daß nach dem Korrigieren die korrigierten Bereiche von den unkorrigierten mit dem bloßen Auge praktisch nicht unterscheidbar sind.

▲ = Farbschleier

## 5. Wasserführung

Beim Drucken soll möglichst wenig Wischwasser benötigt werden. Dadurch wird verhindert, daß die Farbe emulgiert, und daß das Papier feucht und wellig wird. Außerdem wirkt die Farbe auf dem Papier um so brillanter je weniger Wischwasser verwendet wurde. Schließlich ist der Wischwasserverbrauch ein erheblicher Kostenfaktor.

▢ = Wasserführung

Zur Beurteilung der vorgenannten Parameter wurden Bewertungszahlen von 1 - 6 eingeführt, die das Verhalten der untersuchten Werkstoffe mit hohen Punktzahlen bei guten und niedrigen Punktzahlen bei schlechten Ergebnissen wiedergeben sollen. Bei der Rauhigkeit wurde als Meßwert die Rauhtiefe, bei der Wasserführung der Wischwasserverbrauch mit einer Punktzahl bewertet. Die übrigen Parameter wurden nach dem optischen Eindruck in die entsprechenden Klassen eingeteilt. Das Ergebnis ist aus Tabelle 2 ersichtlich. Man erkennt, daß im erfindungsgemäßen Bereich mit 0,1 - 0,3 % Mangan die Kriterien für die elektrochemische Aufrauhung im Vergleich zu dem Werkstoff Al 99,5 nicht wesentlich abfallen. Damit ist der Vorteil, den die erfindungsgemäße Legierung bei der Thermostabilität gegenüber Al 99,5 aufweist nicht durch einen wesentlichen Nachteil bei den übrigen Eigenschaften erkauft worden. Das Ergebnis stellt sich damit als Optimum bei der elektrochemischen Aufrauhung in HCl- und $HNO_3$-Bädern dar, wobei die Legierungszusammensetzung der Aluminiumflachdruckform in engen Grenzen gehalten werden muß und die Gefügeausbildung durch das spezielle Herstellungsverfahren erzielt wird.

4

Tabelle 1

| Werkstoff | Zugfestigkeit Rm (N/mm$^2$) nach Glühbehandlungen | |
|---|---|---|
| Al 99,5 (Standard) | 22 $^{\circ}$C | : 159 - 167 |
| | 5 min 230 $^{\circ}$C | : 130 - 139 |
| | 8 min 240 $^{\circ}$C | : 120 - 130 |
| | 8 min 250 $^{\circ}$C | : 118 - 127 |
| | 1 Std.240 $^{\circ}$C | : 98 - 105 |
| AlMn-Legierung nach Erfindung 0,28 Fe 0,13 Si 0,12 Mn Rest Al | 22 $^{\circ}$C | : 190 - 205 |
| | 5 min 230 $^{\circ}$C | : 188 - 193 |
| | 8 min 240 $^{\circ}$C | : 177 - 185 |
| | 8 min 250 $^{\circ}$C | : 165 - 179 |
| | 1 Std.240 $^{\circ}$C | : 150 - 160 |
| AlMn1Cu (AA 3003) | 22 $^{\circ}$C | : 245 - 260 |
| | 1 Std. 240 $^{\circ}$C | : 200 - 205 |

Tabelle 2

Bewertung der (in HCl und HNO₃) aufgerauhten und beschichteten Platten

Al Mn 1   Al Mn 0,5   Al Mn 0,3   Al Mn 0,2   Al Mn 0,1   Al 99,5

Wertung  6  5  4  3  2  1

## Patentansprüche

1. Trägermaterial für eine Aluminiumflachdruckform, bestehend aus 0,2 - 0,6 % Eisen, weniger als 1 % Mangan, weniger als 0,25 % Silizium und Kupfer, Rest Aluminium und herstellungsbedingte Verunreinigungen, gekennzeichnet durch einen Mangangehalt von 0,1 - 0,3 %, Sekundärausscheidungen in Form

6

von Phasen des Typs AlMnSi: AlFe : AlMn, die sich verhalten wie 1 : 1 : 2 bis 1 : 1 : 3, wobei die mittlere Teilchengröße 0,05 - 0,10 $\mu$m bei einer maximalen Teilchengröße <0,3 $\mu$m beträgt und durch ein Ausscheidungsgefüge mit einem Dispersionsgrad D <50 Phasen pro $\mu m^3$.

2. Trägermaterial für eine Aluminiumflachdruckform nach Anspruch 1, dadurch gekennzeichnet, daß es aus 0,27 - 0,29 % Eisen, 0,12 bis 0,14 % Silizium, 0,11 - 0,13 % Mangan, Rest Aluminium und herstellungsbedingte Verunreinigungen besteht.

3. Trägermaterial nach Anspruch 1 oder 2, dadurch gekennzeichnet, daß es mechanisch und/oder chemisch und/oder elektrochemisch aufgerauht ist.

4. Trägermaterial nach Anspruch 3, dadurch gekennzeichnet, daß es durch eine elektrochemische HCl- oder $HNO_3$-Behandlung aufgerauht ist.

5. Trägermaterial nach Anspruch 3 oder 4, dadurch gekennzeichnet, daß es eine Oxidschicht trägt.

6. Trägermaterial nach einem der Ansprüche 3 bis 5, dadurch gekennzeichnet, daß es eine hydrophile Schicht trägt.

7. Trägermaterial nach einem der Ansprüche 1 bis 6, dadurch gekennzeichnet, daß es mit einer lichtempfindlichen Beschichtung versehen ist.

8. Verfahren zur Herstellung eines Trägermaterials nach einem der Ansprüche 1 oder 2, dadurch gekennzeichnet, daß ein Barren mit einem Mangangehalt von 0,1 - 0,3 %, Sekundärausscheidungen in Form von Phasen des Typs AlMnSi:AlFe:AlMn, die sich verhalten wie 1:1:2 bis 1:1:3, wobei die mittlere Teilchengröße 0,05 - 0,10 $\mu$m bei einer maximalen Teilchengröße <0,3 $\mu$m beträgt und durch ein Ausscheidungsgefüge mit einem Disersionsgrad D <50 Phasen pro $\mu m^3$ und einer Dicke von 400 - 600 mm nach dem Stranggießen mit einer Metalltemperatur von 550 - 600 °C und einer Haltezeit von mindestens 4 Stunden homogenisiert wird, danach ein Warmwalzen bei 460 - 550 °C Metalltemperatur erfolgt, wobei die Warmbandausbringungstemperatur bei 300 - 330 °C liegt und die Warmbandenddikke zwischen 2,5 und 3,5 mm beträgt und daß nach Abkühlung auf Raumtemperatur ein Kaltwalzen an Enddicke von 0,5 - 0,1 mm vorgenommen wird.

9. Verfahren nach Anspruch 8, gekennzeichnet durch ein mehrstufiges Kaltwalzen mit einer Zwischenglühung bei 320 - 380 °C und einer Haltezeit von mindestens 3 Stunden, wobei die anschließende Dickenreduzierung an Enddicke mindestens 70 % beträgt.

10. Verfahren nach einem der Ansprüche 8 oder 9, dadurch gekennzeichnet, daß man anschließend eine mechanische und/oder chemische und/oder elektrochemische Aufrauhung vornimmt.

11. Verfahren nach Anspruch 10, dadurch gekennzeichnet, daß die elektrochemische Aufrauhung ggf. nach vorheriger mechanischer und/oder chemischer Aufrauhung entweder in einem Salzsäuresystem mit 0,4 - 2 % HCl, einer Stromdichte von 50 - 200 A pro d/$m^2$, einer Spannung von 20 - 60 V, einer Verweilzeit von 5 - 30 sec bei einer Temperatur von 35 - 50 °C oder durch eine Behandlung in 0,4 - 2 % $HNO_3$ bei einer Stromdichte von 50 - 200 A pro d/$m^2$, einer Spannung von 20 - 60 V, einer Verweilzeit von 5 - 30 sec und einer Temperatur von 40 - 55 °C aufrauht.

12. Verfahren zum elektrochemischen Aufrauhen nach Anspruch 11, dadurch gekennzeichnet, daß man vor dem Aufrauhen eine alkalische Beizbehandlung in 1 - 6 %-iger NaOH bei 45 - 55 °C für 10 - 60 sec vornimmt.

13. Verfahren zum Aufrauhen nach einem der Ansprüche 11 oder 12, dadurch gekennzeichnet, daß man nach der Aufrauhung eine Anodisierung durchführt.

14. Verfahren zum Aufrauhen nach Anspruch 13, dadurch gekennzeichnet, daß die Anodisierung in $H_2SO_4$ durchgeführt wird.

15. Verfahren zum Aufrauhen nach einem der Ansprüche 13 oder 14, dadurch gekennzeichnet, daß man

EP 0 289 844 B1

zwischen der Aufrauhung und der Anodisierung eine Zwischenbeizung vornimmt.

16. Verfahren zum Aufrauhen nach einem der Ansprüche 13 bis 15, dadurch gekennzeichnet, daß nach der Aufrauhung und/oder der Anodisierung eine hyrophilierende Nachbehandlung durchgeführt wird.

17. Verfahren zum Aufrauhen nach einem der Ansprüche 13 bis 16, dadurch gekennzeichnet, daß die Nachbehandlung mit PVPS vorgenommen wird.

18. Verfahren nach Anspruch 15, dadurch gekennzeichnet, daß die Zwischenbeizung in Schwefelsäure mit 50 - 350 g/l $H_2SO_4$ bei einer Temperatur von 45 - 75 °C während einer Zeit von 3 - 30 sec erfolgt.

19. Verfahren Anspruch 13 oder 14, dadurch gekennzeichnet, daß die Anodisierung mit einer Spannung von 15 - 60 V bei einer Temperatur von 30 - 60 °C erfolgt bis das Oxidgewicht 1 - 6 g/m² beträgt.

20. Verfahren nach Anspruch 16, dadurch gekennzeichnet, daß die Nachbehandlung in 1 - 5 %-iger Polyvinylphosphonsäure bei Temperaturen von 45 - 90 °C für 3 - 30 sec erfolgt.

**Claims**

1. Support material for an aluminium planographic printing mould, consisting of 0.2 - 0.6% iron, less than 1% manganese, less than 0.25% silicon and copper, and the remainder aluminium and impurities resulting from manufacture, characterised by a manganese content of 0.1 - 0.3%, secondary precipitates in the form of phases of the type AlMnSi: AlFe: AlMn, which have the ratio 1: 1: 2 to 1: 1: 3, the average particle size being 0.05 - 0.10μm with a maximum particle size of <0.3μm and by a precipitate structure with a dispersion D of <50 phases per μm³.

2. Support material for an aluminium planographic printing mould according to claim 1, characterised in that it consists of 0.27 - 0.29% iron, 0.12 - 0.14% silicon, 0.11 - 0.13% manganese, and the remainder aluminium and impurities resulting from manufacture.

3. Support material according to claim 1 or 2, characterised in that it is roughened mechanically and/or chemically and/or electrochemically.

4. Support material according to claim 3, characterised in that it is roughened by electrochemical treatment with HCl or $HNO_3$.

5. Support material according to claim 3 or 4, characterised in that it carries an oxide layer.

6. Support material according to one of claims 3 to 5, characterised in that it carries a hydrophilic layer.

7. Support material according to one of claims 1 to 6, characterised in that it is provided with a photosensitive coating.

8. Process for manufacturing a support material according to either of claims 1 or 2, characterised in that a bar with a manganese content of 0.1 - 0.3%, secondary precipitates in the form of phases of the type AlMnSi: AlFe: AlMn in a ratio of something like 1:1:2 to 1:1:3, wherein the average particle size is 0.05 - 0.10μm with a maximum particle size of <0.3μm and is homogenised by a precipitate structure with a dispersion D of <50 phases per μm³ and a thickness of 400 - 600 mm after continuous casting with a metal temperature of 550 - 600°C and a holding time of at least 4 hours, then hot rolling is carried out at 460 - 550°C metal temperature, the hot strip production temperature being 300 - 330°C and the hot strip thickness being between 2.5 and 3.5 mm, and in that after cooling to room temperature cold rolling is carried out to a final thickness of 0.5 - 0.1 mm.

9. Process according to claim 8 characterised by multiple-stage cold rolling with intermediate annealing at 320 - 380°C and a holding time of at least 3 hours, the thickness subsequently being reduced to a final thickness of less than 70%.

10. Process according to either of claims 8 or 9, characterised in that mechanical and/or chemical and/or

8

electrochemical roughening is then carried out.

**11.** Process according to claim 10, characterised in that electrochemical roughening roughens optionally after prior mechanical and/or chemical roughening either in a hydrochloric acid system with 0.4 - 2% HCl, a current density of 50 - 200 per $d/m^3$, a voltage of 20 - 60 V, a holding time of 5 - 30 sec., and at a temperature of 35 - 50°C or by a treatment in 0.4 - 2% $HNO_3$ at a current density of 50 - 200 A $d/m^2$, a voltage of 20 - 60 V, a holding time of 5 - 30 sec., and a temperature of 40 - 55°C.

**12.** Process for electrochemical roughening according to claim 11, characterised in that before roughening, an alkaline pickling treatment is carried out first in 1 - 6% NaOH at 45 - 55°C for 10 - 60 sec..

**13.** Process for roughening according to either of claims 11 or 12, characterised in that after roughening anodising is carried out.

**14.** Process for roughening according to claim 13, characterised in that anodising is carried out in $H_2SO_4$.

**15.** Process for roughening according to either of claims 13 or 14, characterised in that between roughening and anodising, intermediate pickling is carried out.

**16.** Process for roughening according to one of claims 13 to 15, characterised in that after roughening and/or anodising, a hydrophilising after-treatment is carried out.

**17.** Process for roughening according to one of claims 13 to 16, characterised in that the after-treatment is carried out with PVPS.

**18.** Process according to claim 15, characterised in that the intermediate pickling is carried out in sulphuric acid with 50 - 350 g/l $H_2SO_4$ at a temperature of 45 - 350°C for a period of 3 - 30 sec..

**19.** Process according to claim 13 or 14, characterised in that anodising is carried out at a voltage of 15 - 60 V at a temperature of 30 - 60°C until the oxide weight is 1 - 6 $g/m^2$.

**20.** Process according to claim 16, characterised in that after-treatment is carried out in 1 - 5% polyvinylphosphonic acid at temperatures of 45 - 90°C for 3 - 30 sec..

## Revendications

**1.** Matériau support pour un cliché d'impression offset en aluminium, comprenant 0,2-0,6 % de fer, moins de 1 % de manganèse, moins de 0,25 % de silicium et de cuivre, le reste étant l'aluminium et les impuretés dues à la fabrication, caractérisé par une teneur en manganèse de 0,1 - 0,3 %, des précipitations secondaires sous forme de phases du type AlMnSi : AlFe : AlMn, qui sont en proportion de 1 : 1 : 2 à 1 : 1 : 3, la taille de particule moyenne étant 0,05 - 0,10 $\mu$m pour une taille maximale de particule < 0,3 $\mu$m et par une structure à précipitation avec un taux de dispersion D < 50 phases par $\mu m^3$.

**2.** Matériau support pour un cliché d'impression offset en aluminium selon la revendication 1, caractérisé en ce qu'il comprend 0,27 - 0,29 % de fer, 0,12 à 0,14 % de silicium, 0,11 - 0,13 % de manganèse, le reste étant de l'aluminium et des impuretés de fabrication.

**3.** Matériau support selon la revendication 1 ou 2, caractérisé en ce qu'on le rend rugueux mécaniquement et/ou chimiquement et/ou électrochimiquement.

**4.** Matériau support selon la revendication 3, caractérisé en ce qu'on le rend rugueux par un traitement électrochimique à HCl ou $HNO_3$.

**5.** Matériau support selon la revendication 3 ou 4, caractérisé en ce qu'il porte une couche d'oxyde.

**6.** Matériau support selon l'une des revendications 3 à 5, caractérisé en ce qu'il porte une couche hydrophile.

**7.** Matériau support selon l'une des revendications 1 à 6, caractérisé en ce qu'il a un revêtement sensible à la lumière.

**8.** Procédé de production d'un matériau support selon l'une des revendications 1 ou 2, caractérisé en ce qu'on homogénéise un lingot ayant une teneur en manganèse de 0,1 - 0,3 %, des précipitations secondaires sous forme de phases du type AlMnSi : AlFe : AlMn, qui sont en proportion de 1 : 1 : 2 à 1 : 1 : 3, la taille de particule moyenne étant 0,05 - 0,10 $\mu$m pour une taille maximale de particule < 0,3 $\mu$m et par une structure à précipitation avec un taux de dispersion D < 50 phases par $\mu$m$^3$ et une épaisseur de 400 - 600 mm après l'extrusion avec une température de métal de 550 - 600°C et un temps de maintien d'au moins 4 heures, ensuite on réalise un laminage à chaud pour une température de 460 - 550°C, la température de maintien de la bande étant de 300 - 330°C et l'épaisseur de la bande chaude étant comprise entre 2,5 et 3,5 mm et après refroidissement à température ambiante on réalise un laminage à froid de 0,5 - 0,1 mm à l'épaisseur finale.

**9.** Procédé selon la revendication 8, caractérisé par un laminage à froid en plusieurs étapes avec une cuisson intermédiaire à 320 - 380°C et un temps de maintien d'au moins 3 heures, la diminution d'épaisseur consécutive à l'épaisseur finale représentant au moins 70 %.

**10.** Procédé selon l'une des revendications 8 ou 9, caractérisé en ce qu'on réalise ensuite un traitement de rugosité mécanique et/ou chimique et/ou électrochimique.

**11.** Procédé selon la revendication 10, caractérisé en ce qu'on réalise le traitement de rugosité électrochimique le cas échéant après traitement de rugosité antérieur mécanique et/ou chimique, soit dans un système à l'acide chlorhydrique avec 0,4 - 2 % de HCl, une densité de courant de 50 - 200 A par dm$^2$, une tension de 20-60 V, un temps de séjour de 5-30 sec à une température de 35-50°C soit par un traitement dans une solution de 0,4-2 % de HNO$_3$ sous une densité de courant de 50-200 A par dm$^2$, une tension de 20-60 V, un temps de séjour de 5-30 sec et une température de 40-55°C.

**12.** Procédé de traitement de rugosité électrochimique selon la revendication 11, caractérisé en ce qu'on réalise avant le traitement de rugosité un traitement d'attaque alcaline dans de la soude à 1-6 % à 45-55°C pendant 10-60 sec.

**13.** Procédé de traitement de rugosité selon l'une des revendications 11 ou 12, caractérisé en ce qu'après le traitement de rugosité on réalise une anodisation.

**14.** Procédé de traitement de rugosité selon la revendication 13, caractérisé en ce qu'on réalise l'anodisation dans H$_2$SO$_4$.

**15.** Procédé de traitement de rugosité selon l'une des revendications 13 ou 14, caractérisé en ce qu'on réalise une anodisation entre le traitement de rugosité et l'anodisation.

**16.** Procédé de traitement de rugosité selon l'une des revendications 13 à 15, caractérisé en ce qu'après le traitement de rugosité et/ou l'anodisation on réalise un post-traitement qui rend hydrophile.

**17.** Procédé de traitement de rugosité selon l'une des revendications 13 à 16, caractérisé en ce qu'on réalise le post-traitement avec le PVPS.

**18.** Procédé selon la revendication 15, caractérisé en ce qu'on réalise l'attaque intermédiaire dans l'acide sulfurique avec 50-35O g/l de H$_2$SO$_4$ à une température de 45 - 75°C pendant une durée de 3 - 30 sec.

**19.** Procédé selon la revendication 13 ou 14, caractérisé en ce qu'on réalise l'anodisation sous une tension de 15 - 60 V à une température de 30 - 60°C jusqu'à un poids d'oxyde de 1-6 g/m$^2$.

**20.** Procédé selon la revendication 16, caractérisé en ce que le post-traitement se fait dans une solution d'acide polyvinylphosphonique à 1 - 5 % à une température de 45 - 90°C pendant 3 - 30 sec.